# EUROPEAN PATENT APPLICATION

(11) **EP 4 739 023 A1**
(43) Date of publication of application: **06.05.2026**
(21) Application number: 25211302.2
(22) Date of filing: 27.10.2025
(51) Int. Cl.: H10B 12/00, H10W 20/20, H10W 90/00

(54) **SEMICONDUCTOR DEVICE INCLUDING MULTIPLE DIES**

(30) Priority: 31.10.2024 KR 20240152967
(71) Applicant: Samsung Electronics Co., Ltd., Suwon-si, Gyeonggi-do 16677 (KR)
(72) Inventor: KANG, Pilkyu, 16677 Suwon-si, Gyeonggi-do (KR); PARK, Jaewha, 16677 Suwon-si, Gyeonggi-do (KR); MOON, Kwangjin, 16677 Suwon-si, Gyeonggi-do (KR); KIM, Eunmi, 16677 Suwon-si, Gyeonggi-do (KR); LEE, Chanmi, 16677 Suwon-si, Gyeonggi-do (KR)
(74) Representative: Kuhnen & Wacker Patent- und Rechtsanwaltsbüro PartG mbB

(57) **Abstract**

A semiconductor device may include a plurality of dies (10) stacked in a vertical direction (Z), wherein each of the plurality of dies (10) includes: a first substrate (110); a cell capacitor (CAP) on the first substrate (110); a cell transistor (CTR) on the cell capacitor (CAP); a second substrate (210), wherein a vertical level of the second substrate (210) is higher than a vertical level of the cell transistor (CTR); a peripheral circuit transistor (PTR) on the second substrate (210); and a through via (12) passing through the first substrate (110) and the second substrate (210) in the vertical direction (Z).

## Description

### BACKGROUND

The disclosure relates to a semiconductor device, and more particularly, to a semiconductor device having a stack structure of a plurality of dies.

To enhance the performance and storage capacity of semiconductor devices, semiconductor devices having a structure where a plurality of semiconductor dies are stacked are being used widely. As semiconductor devices are down-scaled, the size of dynamic random access memory (DRAM) devices is also reduced, and in DRAM devices having a 1T-1C structure where one capacitor is connected to one transistor, there is a problem where a leakage current occurring through a channel region increases progressively. Therefore, there is a need for vertical channel transistors including a channel layer extending in a vertical direction for decreasing a leakage current.

### SUMMARY

One or more embodiments provide a semiconductor device having a structure where a plurality of semiconductor dies including a vertical channel transistor having good electrical performance are stacked.

According to an aspect of the disclosure, a semiconductor device may include a plurality of dies stacked in a vertical direction, wherein each of the plurality of dies includes: a first substrate; a cell capacitor on the first substrate; a cell transistor on the cell capacitor; a second substrate, wherein a vertical level of the second substrate is higher than a vertical level of the cell transistor; a peripheral circuit transistor on the second substrate; and a through via passing through the first substrate and the second substrate in the vertical direction.

According to an aspect of the disclosure, a semiconductor device may include: a first die; and a second die on the first die, wherein each of the first die and the second die includes: a first substrate; a cell capacitor on the first substrate; a cell transistor on the cell capacitor; a second substrate, wherein a vertical level of the second substrate is higher than a vertical level of the cell transistor; a peripheral circuit transistor on the second substrate; a through via passing through the first substrate and the second substrate in a vertical direction; a wiring pattern that at least partially vertically overlaps with the through via, wherein a vertical level of the wiring pattern is higher than a vertical level of the peripheral circuit transistor; a front-side pad (14P) on an upper surface of the wiring pattern; and a backside pad on a lower surface of the through via.

According to an aspect of the disclosure, a semiconductor device may include: a first substrate including a first through via hole; a cell capacitor on the first substrate; a cell transistor on the cell capacitor; a second substrate, wherein a vertical level of the second substrate is higher than a vertical level of the cell transistor, and the second substrate includes a second through via hole that vertically overlaps with the first through via hole; a peripheral circuit transistor on the second substrate; a through via contact extending in a vertical direction in a via hole passing through the second substrate, and the through via contact electrically connects the peripheral circuit transistor to the cell transistor; a through via passing through the first through via hole and the second through via hole in the vertical direction; a through via insulation layer on a sidewall of the through via; a wiring pattern at least partially vertically overlapping with the through via, wherein a vertical level of the wiring pattern is higher than a vertical level of the peripheral circuit transistor; a front-side pad on an upper surface of the wiring pattern; a front-side insulation layer on the upper surface of the wiring pattern, and an upper surface of the front-side insulation layer being coplanar with an upper surface of the front-side pad; a backside pad on a lower surface of the through via; and a backside insulation layer on a lower surface of the first substrate, and a lower surface of the backside insulation layer being coplanar with a lower surface of the backside pad.

### BRIEF DESCRIPTION OF DRAWINGS

Embodiments will be more clearly understood from the following detailed description taken in conjunction with the accompanying drawings in which:
FIG. 1 is a schematic diagram illustrating a semiconductor device according to embodiments;
FIG. 2 is a perspective view schematically illustrating each semiconductor die of FIG. 1;
FIG. 3 is a cross-sectional view illustrating a region A of FIG. 1;
FIG. 4 is a cross-sectional view schematically illustrating a cell array region of FIG. 2;
FIG. 5 is a cross-sectional view schematically illustrating a cell array region according to embodiments; and
FIGS. 6 to 8, 9A, 9B, 10 to 21, 22A, and 22B are schematic diagrams illustrating a method of manufacturing a semiconductor device, according to embodiments.

### DETAILED DESCRIPTION

It will be understood that when an element or layer is referred to as being "on," "connected to," or "coupled to" another element or layer, it can be directly on, connected to, or coupled to the other element or layer or intervening elements or layers may be present. In contrast, when an element or layer is referred to as being "directly on," "directly connected to," or "directly coupled to" another element or layer, there are no intervening elements or layers present.

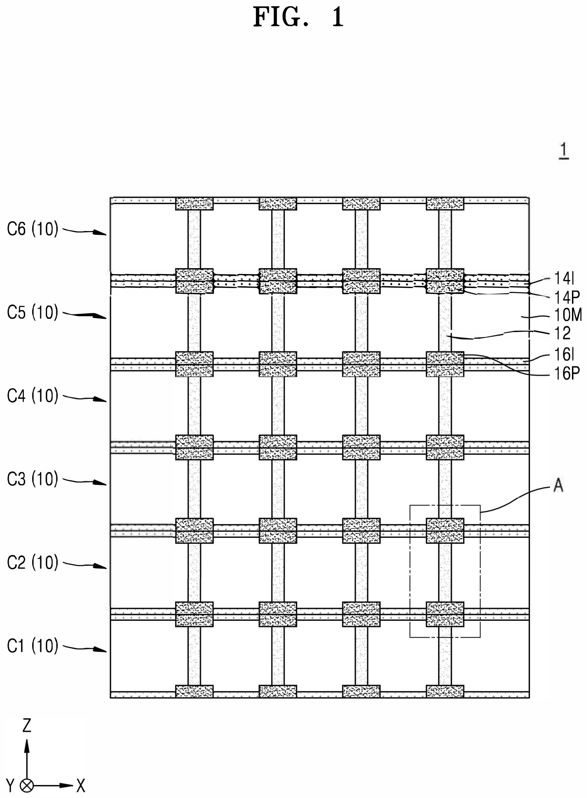

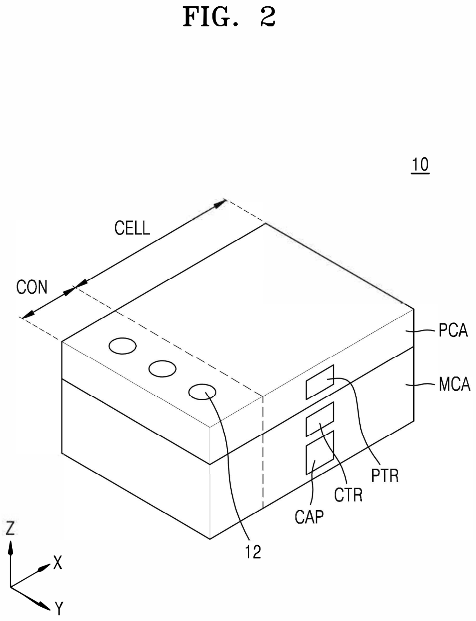

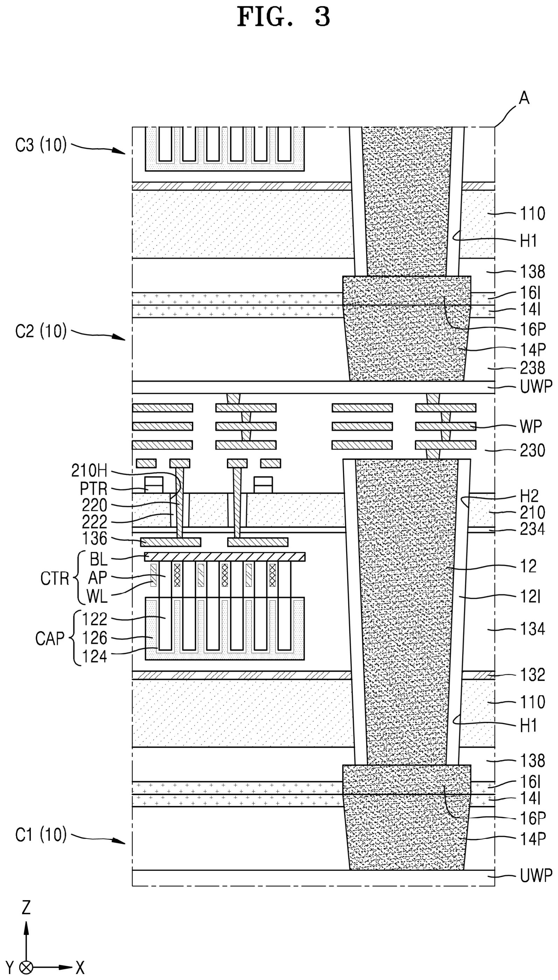

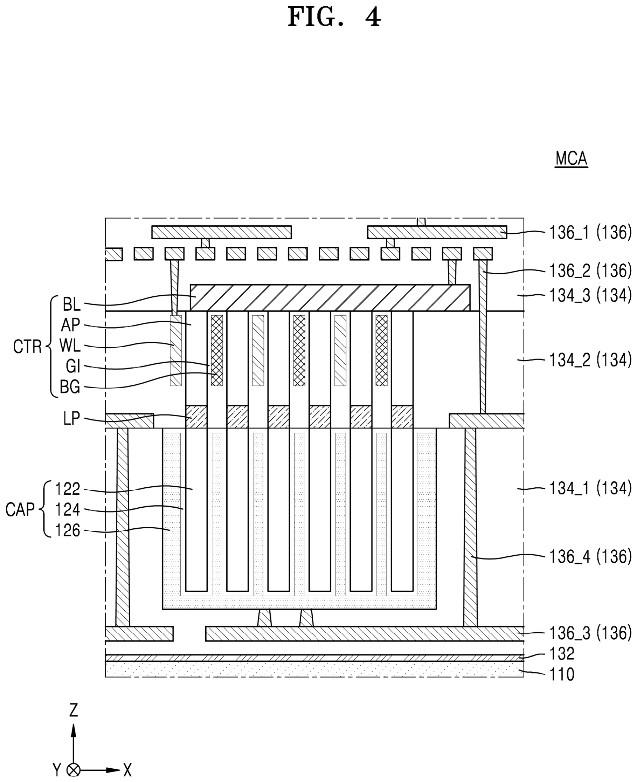

FIG. 1 is a schematic diagram illustrating a semiconductor device 1 according to embodiments. FIG. 2 is a perspective view schematically illustrating each semiconductor die 10 of FIG. 1. FIG. 3 is a cross-sectional view illustrating a region A of FIG. 1. FIG. 4 is a cross-sectional view schematically illustrating a cell array region MCA of FIG. 2.

Referring to FIGS. 1 to 4, the semiconductor device 1 may include a plurality of semiconductor dies 10, which may be stacked in a vertical direction Z. Each of the plurality of semiconductor dies 10 may be disposed at an overlapping position in the vertical direction Z, and each of the plurality of semiconductor dies 10 may be electrically connected to a corresponding semiconductor die 10.

In embodiments, each of the plurality of semiconductor dies 10 may include a memory chip (e.g., a dynamic random access memory (DRAM) device). In embodiments, each of the plurality of semiconductor dies 10 may be a high bandwidth memory (HBM) device. In embodiments, the plurality of semiconductor dies 10 may not be disposed on a buffer die, and the semiconductor device 1 may be a buffer-less semiconductor device.

In other embodiments, the plurality of semiconductor dies 10 may be attached to the buffer die, and the buffer die may include a logic chip. In embodiments, the plurality of semiconductor dies 10 may be attached to a partial region of an interposer, and the logic chip may be mounted in another region of the interposer.

In embodiments, each of the plurality of semiconductor dies 10 may include at least one through via 12, which passes through a die body 10M and extends in the vertical direction Z. Each of the plurality of semiconductor dies 10 may include at least one front-side pad 14P, which is provided at (e.g., in or on) an uppermost surface of a corresponding semiconductor die 10, and at least one backside pad 16P, which is provided at (e.g., in or on) a lowermost surface of the corresponding semiconductor die 10. In embodiments, the at least one front-side pad 14P and the at least one backside pad 16P may be electrically connected to the at least one through via 12.

In embodiments, each of the plurality of semiconductor dies 10 may include a front-side insulation layer 14I that defines an uppermost surface of a corresponding semiconductor die 10, and a backside insulation layer 16I that defines a lowermost surface of the corresponding semiconductor die 10. The front-side insulation layer 14I may be disposed on an upper surface of the die body 10M of the semiconductor die 10, and the front-side insulation layer 14I may include an upper surface, which may be disposed coplanar with an upper surface of the front-side pad 14P. The backside insulation layer 16I may be disposed on a lower surface of the die body 10M of the semiconductor die 10, and the backside insulation layer 16I may include a lower surface, which may be disposed coplanar with a lower surface of the backside pad 16P.

In embodiments, the plurality of semiconductor dies 10 may be attached or adhered to each other by a metal-oxide hybrid bonding process. In embodiments, a front-side pad 14P included in one semiconductor die 10 may contact a backside pad 16P included in another one semiconductor die 10 disposed immediately on the one semiconductor die 10, and a front-side insulation layer 14I included in the one semiconductor die 10 may contact a backside insulation layer 16I included in the other one semiconductor die 10 disposed immediately on the one semiconductor die 10.

In embodiments, the plurality of semiconductor dies 10 may include a first die C1, a second die C2, a third die C3, a fourth die C4, a fifth die C5, and a sixth die C6, which may be stacked in the vertical direction Z. In embodiments, a front-side pad 14P included in the first die C1 may contact a backside pad 16P included in the second die C2, and a front-side insulation layer 14I included in the first die C1 may contact a backside insulation layer 16I included in the second die C2. Also, a front-side pad 14P included in the second die C2 may contact a backside pad 16P included in the third die C3, and a front-side insulation layer 14I included in the second die C2 may contact a backside insulation layer 16I included in the third die C3. Relationships between the third die C3, the fourth die C4, the fifth die C5, and the sixth die C6 may be the same as or similar to the relationships described above with respect to the first die C2, the second die C2, and the third die C3. In this manner, the plurality of semiconductor dies 10 may be stacked in the vertical direction Z by a metal-oxide hybrid bonding process.

In embodiments, the number of semiconductor dies 10 stacked in the vertical direction Z is not limited to the number illustrated in FIG. 1. For example, the number of semiconductor dies 10 may be 2 to 5 or 7 to 100.

In embodiments, each of the plurality of semiconductor dies 10 may include a DRAM device having a one transistor - one capacitor (1T-1C) structure where one cell transistor CTR (see FIG. 2) is electrically connected to one cell capacitor CAP (see FIG. 2).

As illustrated in FIG. 2, each of the plurality of semiconductor dies 10 may include a cell region CELL and a connection region CON. The cell region CELL of each of the plurality of semiconductor dies 10 may be a region where the cell transistor CTR, the cell capacitor CAP, and a peripheral circuit transistor PTR are disposed, and the connection region of each of the plurality of semiconductor dies 10 may be a region where the at least one through via 12 is disposed.

In embodiments, the cell region CELL may include a cell array region MCA and a peripheral circuit region PCA, which are disposed at different vertical levels with respect to each other. The cell array region MCA and the peripheral circuit region PCA may overlap each other in the vertical direction Z. As illustrated in FIG. 1, the peripheral circuit region PCA may be disposed on the cell array region MCA, and each of the semiconductor devices (e.g., the semiconductor dies 10) may have a periphery over cell (POC) structure.

In embodiments, the cell array region MCA may be a memory cell region of the DRAM device, and for example, the cell transistor CTR and the cell capacitor CAP may be disposed in the cell array region MCA. In embodiments, the peripheral circuit region PCA may be a core region or a peripheral circuit region of the DRAM device. The peripheral circuit region PCA may include the peripheral circuit transistor PTR for transferring a signal and/or power to the cell transistor CTR and the cell capacitor CAP each included in the cell array region MCA. In embodiments, the peripheral circuit transistor PTR may configure various circuits such as a command decoder, a control logic, an address buffer, a row decoder, a column decoder, a sense amplifier, and a data input/output (I/O) circuit.

In embodiments, the peripheral circuit region PCA may be attached to the cell array region MCA by a bonding process. In embodiments, the peripheral circuit region PCA may be attached to the cell array region MCA by an oxide bonding process.

As illustrated in FIG. 3, each of the semiconductor dies 10 may include a first substrate 110, the cell capacitor CAP disposed on the first substrate 110, and the cell transistor CTR disposed on the cell capacitor CAP. Also, each of the semiconductor dies 10 may include a second substrate 210 disposed at a vertical level which is higher than a vertical level of the first substrate 110, and may include the peripheral circuit transistor PTR disposed on the second substrate 210. Each of the semiconductor dies 10 may include the at least one through via 12, which passes through the first substrate 110 and the second substrate 210 and extends in the vertical direction Z.

Each of the semiconductor dies 10 may include a wiring pattern WP disposed at a vertical level which is higher than a vertical level of the peripheral circuit transistor PTR. The wiring pattern WP may be electrically connected to the peripheral circuit transistor PTR and the second substrate 210 and may include a portion which vertically overlaps with the at least one through via 12. The portion of the wiring pattern WP may be disposed to cover an upper surface of the through via 12. The wiring pattern WP may include a multilayer of a plurality of metal wiring lines. A wiring insulation layer 230 may be further disposed on an upper surface, a sidewall, and a lower surface of each of the plurality of metal wiring lines included in the wiring pattern WP.

Each of the semiconductor dies 10 may include a third interlayer insulation layer 238, the at least one front-side pad 14P, and the front-side insulation layer 14I, which may be disposed on the upper surface of the wiring pattern WP.

In some embodiments, the at least one front-side pad 14P may include copper or a copper alloy. At least a portion of a sidewall of the at least one front-side pad 14P may be surrounded by the front-side insulation layer 14I and the third interlayer insulation layer 238. In embodiments, the third interlayer insulation layer 238 may surround a lower portion of the sidewall of the at least one front-side pad 14P. In embodiments, the front-side insulation layer 14I may be disposed on the third interlayer insulation layer 238 and may surround an upper portion of the sidewall of the at least one front-side pad 14P. In embodiments, the front-side insulation layer 14I may have an upper surface coplanar with the upper surface of the at least one front-side pad 14P.

In some embodiments, the third interlayer insulation layer 238 may include silicon oxide, and the front-side insulation layer 14I may include at least one of silicon oxide, silicon nitride, silicon oxynitride, and silicon carbon nitride.

In some embodiments, a lower pad UWP may be further disposed between the wiring pattern WP and the at least one front-side pad 14P, and the lower pad UWP may include at least one of aluminum, tungsten, copper, and nickel. The lower pad UWP may be formed to have a width which is greater than a width of the front-side pad 14P, and an entire lower surface of the front-side pad 14P may be disposed on a flat upper surface of the lower pad UWP.

Each of the semiconductor dies 10 may include the at least one backside pad 16P connected to a lower end of the at least one through via 12. In some embodiments, the at least one backside pad 16P may include copper or a copper alloy. At least a portion of a sidewall of the at least one backside pad 16P may be surrounded by the backside insulation layer 16I. The backside insulation layer 16I may include a lower surface coplanar with a lower surface of the at least one backside pad 16P. In some embodiments, the backside insulation layer 16I may include at least one of silicon oxide, silicon nitride, silicon oxynitride, and silicon carbon nitride.

In embodiments, the at least one through via 12 may pass through the first substrate 110 and the second substrate 210 and may extend in the vertical direction Z. A through via insulation layer 12I may be disposed on a sidewall of each of the at least one through via 12. In some embodiments, the through via insulation layer 12I may be disposed on the entire sidewall of the through via 12.

In embodiments, the first substrate 110 may include a first through via hole H1 passing through the first substrate 110, and the second substrate 210 may include a second through via hole H2, which passes through the second substrate 210 and is disposed at a position vertically overlapping with the first through via hole H1. The through via 12 may pass through the first through via hole H1 and the second through via hole H2 and may extend in the vertical direction Z, and for example, the through via 12 may extend in the vertical direction Z so that portions of the through via 12 are disposed in the first through via hole H1 and the second through via hole H2. The through via insulation layer 12I may surround a sidewall of the through via 12, may pass through the first through via hole H1 and the second through via hole H2, and may extend in the vertical direction Z.

In embodiments, the through via 12 may include an upper surface disposed at a vertical level which is higher than a vertical level of an upper surface of the second substrate 210, and may include a lower surface disposed at a vertical level which is lower than a vertical level of a lower surface of the first substrate 110. In embodiments, the through via insulation layer 12I may include an upper surface disposed at a vertical level which is higher than a vertical level of an upper surface of the second substrate 210, and may include a lower surface disposed at a vertical level which is lower than a vertical level of a lower surface of the first substrate 110. For example, a first portion of the through via insulation layer 12I may be disposed between an inner wall of the first through via hole H1 and a sidewall of the through via 12, and a second portion of the through via insulation layer 12I may be disposed between an inner wall of the second through via hole H2 and the sidewall of the through via 12. The sidewall of the through via 12 may be surrounded by the through via insulation layer 12I, and thus, the through via 12 may be electrically insulated from the first substrate 110 and the second substrate 210.

In embodiments, the first substrate 110 may include silicon (e.g., polycrystalline silicon, single crystalline silicon, or amorphous silicon). In some other embodiments, the first substrate 110 may include at least one from among germanium (Ge), silicon germanium (SiGe), silicon carbide (SiC), gallium arsenide (GaAs), indium arsenide (InAs), and indium phosphide (InP).

In embodiments, the cell capacitor CAP may be disposed on the first substrate 110, and the cell capacitor CAP may be a capacitor of a metal-insulator-metal (MIM) type. In embodiments, the cell capacitor CAP may include a first electrode 122, a capacitor dielectric layer 124, and a second electrode 126.

In other embodiments, instead of the cell capacitor CAP, a memory component such as a variable resistance memory device, a phase change memory device, or a magnetic memory device may be disposed.

In embodiments, an interface insulation layer 132 may be disposed between the first substrate 110 and the cell capacitor CAP, and a buried insulation layer 134 (e.g., a first buried insulation layer 134_1) may be disposed on the interface insulation layer 132 to surround a lower surface and a sidewall of the cell capacitor CAP. The buried insulation layer 134 may be disposed to cover the cell capacitor CAP on the first substrate 110, and the through via 12 and the through via insulation layer 12I may pass through the buried insulation layer 134 and may extend in the vertical direction Z. In embodiments, at least a portion of a sidewall of the through via insulation layer 12I may contact the buried insulation layer 134.

In embodiments, the cell capacitor CAP may be attached to the first substrate 110 by a bonding process. In embodiments, after the cell capacitor CAP and the first buried insulation layer 134_1 surrounding the cell capacitor CAP are formed, the interface insulation layer 132 may be formed on the first substrate 110, and the interface insulation layer 132 may be attached to the first buried insulation layer 134_1 by an oxide bonding process.

In embodiments, the cell transistor CTR may be a transistor of a vertical channel transistor type. In embodiments, the cell transistor CTR may include a channel layer AP extending in the vertical direction Z, a word line WL disposed on one sidewall of the channel layer AP, a back gate line BG disposed on another sidewall of the channel layer AP, and a bit line BL disposed on an upper surface of the channel layer AP. A gate insulation layer GI may be disposed between the channel layer AP and the word line WL and between the channel layer AP and the back gate line BG.

In embodiments, a landing pad LP may be disposed on a lower surface of the channel layer AP, and the first electrode 122 of the cell capacitor CAP may be disposed to extend in the vertical direction Z with the landing pad LP therebetween.

In embodiments, the channel layer AP may include at least one of silicon, germanium, and silicon germanium. In embodiments, the channel layer AP may be provided in plural, and in some embodiments, the plurality of channel layers AP may be arranged in a matrix form in a first horizontal direction X and a second horizontal direction Y.

In embodiments, a plurality of word lines WL and a plurality of back gate lines BG may be alternately arranged in the first horizontal direction X and may extend in the second horizontal direction Y. In embodiments, the plurality of word lines WL and the plurality of back gate lines BG may include titanium (Ti), titanium nitride (TiN), tantalum (Ta), tantalum nitride (TaN), molybdenum (Mo), molybdenum nitride (MoN), ruthenium (Ru), tungsten (W), tungsten nitride (WN), cobalt (Co), titanium silicon nitride (TiSiN), tungsten silicon nitride (WSiN), or a combination thereof.

In embodiments, the bit line BL may be disposed on the upper surface of the channel layer AP and may extend in the first horizontal direction X. In embodiments, the bit line BL may include Ti, TiN, Ta, TaN, Mo, MoN, Ru, W, WN, Co, TiSiN, WSiN, polysilicon, or a combination thereof.

In embodiments, the gate insulation layer GI may include at least one material from among hafnium oxide (HfO), hafnium silicate (HfSiO), hafnium oxide nitride (HfON), hafnium silicon oxide nitride (HfSiON), lanthanum oxide (LaO), lanthanum aluminum oxide (LaAlO), zirconium oxide (ZrO), zirconium silicon oxide (ZrSiO), zirconium oxide nitride (ZrON), zirconium silicon oxide nitride (ZrSiON), tantalum oxide (TaO), titanium oxide (TiO), barium strontium titanium oxide (BaSrTiO), barium titanium oxide (BaTiO), lead zirconium titanium oxide (PbZrTiO), strontium tantalum bismuth oxide (SrTaBiO), bismuth iron oxide (BiFeO), strontium titanium oxide (SrTiO), yttrium oxide (YO), aluminum oxide (AlO), and lead scandium tantalum oxide (PbScTaO).

In embodiments, the landing pad LP may be disposed between the lower surface of the channel layer AP and the first electrode 122, and the landing pad LP may include Ti, TiN, Ta, TaN, Mo, MoN, Ru, W, WN, Co, TiSiN, WSiN, polysilicon, or a silicide material thereof.

In embodiments, the cell transistor CTR may be covered by the buried insulation layer 134. In embodiments, a portion of the cell transistor CTR including the channel layer AP, the word line WL, and the back gate line BG may be covered by a second buried insulation layer 134_2 of the buried insulation layer 134, and the bit line BL may be covered by a third buried insulation layer 134_3 of the buried insulation layer 134.

In embodiments, a cell wiring structure 136, which may at least partially pass through the buried insulation layer 134 and is electrically connected to the cell capacitor CAP and the cell transistor CTR, may be disposed. The cell wiring structure 136 may include a first wiring 136_1 covered by the second buried insulation layer 134_2 and the third buried insulation layer 134_3, a first contact 136_2 covered by the second buried insulation layer 134_2 and the third buried insulation layer 134_3 and connected to the first wiring 136_1 or the cell transistor CTR, a second wiring 136_3 covered by the first buried insulation layer 134_1, and a second contact 136_4 covered by the first buried insulation layer 134_1 and connected to the second wiring 136_3 or the cell capacitor CAP.

In embodiments, the first wiring 136_1 and the first contact 136_2 may be electrically connected to the cell transistor CTR, and for example, may be electrically connected to the word line WL, the back gate line BG, and/or the bit line BL. In embodiments, the second wiring 136_3 and the second contact 136_4 may be electrically connected to the cell capacitor CAP.

A first interlayer insulation layer 138 may be disposed on the lower surface of the first substrate 110. The first interlayer insulation layer 138 may surround a portion of a sidewall of the through via insulation layer 12I and may surround a portion of a sidewall of the backside pad 16P. The backside insulation layer 16I may be disposed on a lower surface of the first interlayer insulation layer 138.

In embodiments, the second substrate 210 may be disposed at a vertical level which is higher than a vertical level of the first substrate 110. The second substrate 210 may include silicon (e.g., polycrystalline silicon, single crystalline silicon, or amorphous silicon). In some other embodiments, the second substrate 210 may include at least one from among Ge, SiGe, SiC, GaAs, InAs, and InP.

A second interlayer insulation layer 234 may be disposed on a lower surface of the second substrate 210, and a lower surface of the second interlayer insulation layer 234 may contact an upper surface of the buried insulation layer 134 (e.g., the third buried insulation layer 134_3).

The peripheral circuit transistor PTR may be disposed on the upper surface of the second substrate 210. The peripheral circuit transistor PTR may include at least one of a flat-type transistor, a FinFET transistor, a multi-bridge channel transistor, and a buried channel array transistor.

The wiring pattern WP electrically connected to the peripheral circuit transistor PTR and the second substrate 210 may be disposed on the upper surface of the second substrate 210, and the wiring insulation layer 230 covering the peripheral circuit transistor PTR and the wiring pattern WP may be disposed on the upper surface of the second substrate 210.

In embodiments, the via hole 210H may be disposed to pass through the second substrate 210, and a via insulation layer 222 may be disposed in the via hole 210H. The through via contact 220 may pass through the via insulation layer 222 and may extend in the vertical direction Z, and the wiring pattern WP may be electrically connected to the cell wiring structure 136 by the through via contact 220.

According to embodiments, each of the semiconductor dies 10 may include the cell transistor CTR disposed on the first substrate 110, the peripheral circuit transistor PTR disposed on the second substrate 210, and the through via 12 passing through the first substrate 110 and the second substrate 210, and the plurality of semiconductor dies 10 may be stacked in the vertical direction Z and connected together via the front-side pad 14P and the backside pad 16P. The semiconductor device 1 may be high in degree of integration, and moreover, may have good electrical performance.

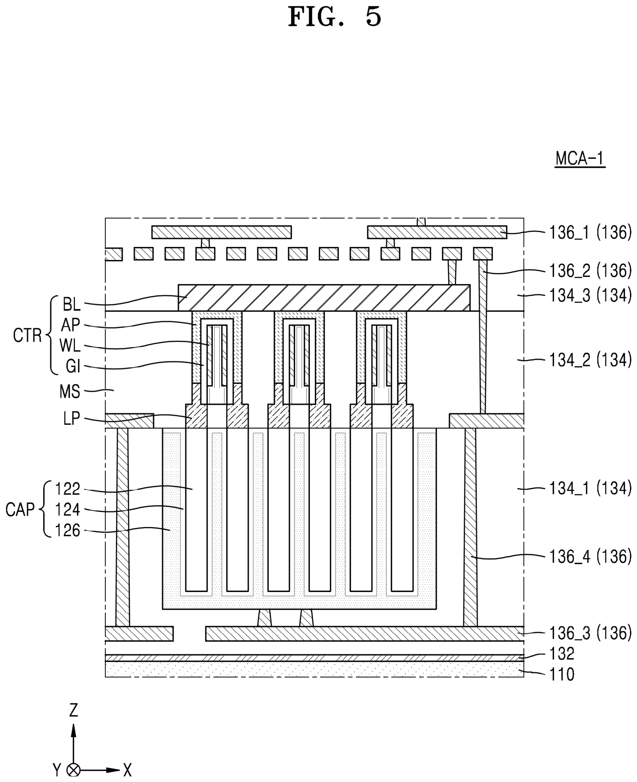

FIG. 5 is a cross-sectional view schematically illustrating a cell array region MCA-1 according to embodiments.

Referring to FIG. 5, a cell transistor CTR may be disposed in an opening portion of a mold insulation layer MS. The cell transistor CTR may include a channel layer AP including a vertical cross-sectional surface having a reversed-U shape. Two word lines WL may be disposed apart from each other between two vertical extension portions of the channel layer AP.

In embodiments, the channel layer AP may include an oxide semiconductor. In embodiments, the oxide semiconductor may include at least one of zinc tin oxide (ZnₓSn_{y}O), indium zinc oxide (InₓZn_{y}O), zinc oxide (ZnOₓ), indium gallium zinc oxide (InₓGa_{y}Zn_{z}O), indium gallium silicon oxide (InₓGa_{y}Si_{z}O), indium tungsten oxide (InₓW_{y}O), indium oxide (InₓO), tin oxide (SnₓO), titanium oxide (TiₓO), zinc oxynitride (ZnₓON_{z}), magnesium zinc oxide (MgₓZn_{y}O), zirconium indium zinc oxide (ZrₓIn_{y}Zn_{z}O), hafnium indium zinc oxide (HfₓIn_{y}Zn_{z}O), tin indium zinc oxide (SnₓIn_{y}Zn_{z}O), aluminum tin indium zinc oxide (AlₓSn_{y}In_{z}ZnₐO), silicon indium zinc oxide (SiₓIn_{y}Zn_{z}O), aluminum zinc tin oxide (AlₓZn_{y}Sn_{z}O), gallium zinc tin oxide (GaₓZn_{y}Sn_{z}O), and zirconium zinc tin oxide (ZrₓZn_{y}Sn_{z}O). In embodiments, the channel layer AP may further include an n-type impurity ion. For example, the n-type impurity ion may be doped in the channel layer AP through an ion implantation process.

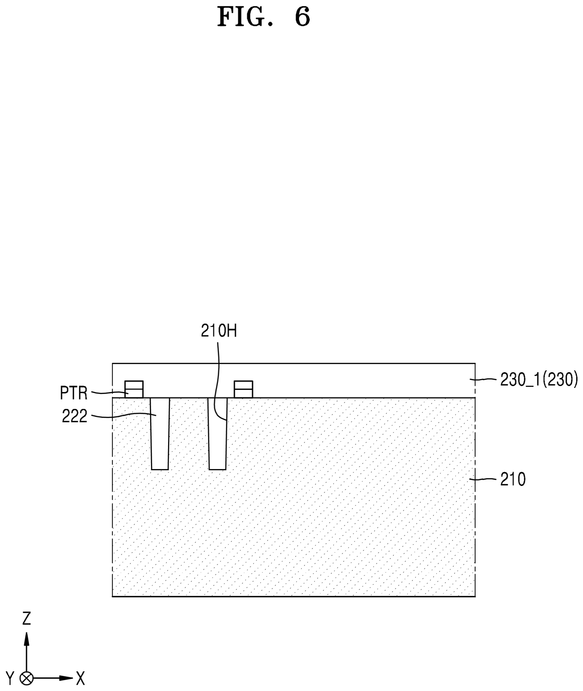

FIGS. 6 to 8, 9A, 9B, 10 to 21, 22A, and 22B are schematic diagrams illustrating a method of manufacturing a semiconductor device 1, according to embodiments.

Referring to FIG. 6, a mask pattern may be formed on a second substrate 210, and a via hole 210H may be formed by removing a portion of the second substrate 210 using the mask pattern as an etch mask. Subsequently, a via insulation layer 222 may be formed in the via hole 210H using an insulating material.

A peripheral circuit transistor PTR may be formed on the second substrate 210, and a first wiring insulation layer 230_1 covering the peripheral circuit transistor PTR may be formed. In embodiments, the first wiring insulation layer 230_1 may include at least one of silicon oxide, silicon nitride, silicon oxynitride, and a low-k dielectric material.

In embodiments, the peripheral circuit transistor PTR may include at least one of a flat-type transistor, a FinFET transistor, a multi-bridge channel transistor, and a buried channel array transistor.

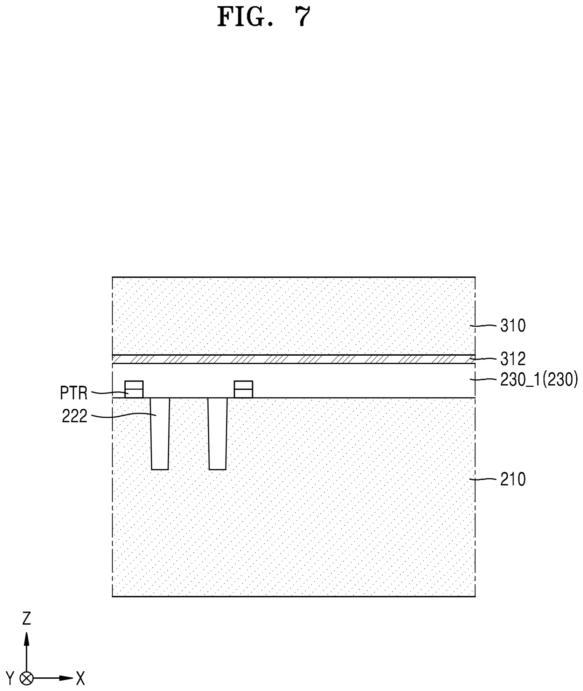

Referring to FIG. 7, a first carrier substrate 310 may be attached to the first wiring insulation layer 230_1. In embodiments, an interface insulation layer 312 may be formed on the first carrier substrate 310, and the interface insulation layer 312 may bond the first carrier substrate 310 to the second substrate 210 to contact an upper surface of the first wiring insulation layer 230_1.

In embodiments, the interface insulation layer 312 may include at least one of silicon oxide, silicon nitride, silicon oxynitride, and silicon carbon nitride.

In some embodiments, the interface insulation layer 312 may be bonded to the first wiring insulation layer 230_1 by an oxide bonding process. In some embodiments, plasma treatment may be performed on a surface of each of the interface insulation layer 312 and the first wiring insulation layer 230_1. In some embodiments, surface treatment using a chemical material may be performed on the surface of each of the interface insulation layer 312 and the first wiring insulation layer 230_1. In some embodiments, high temperature annealing may be performed on the surface of each of the interface insulation layer 312 and the first wiring insulation layer 230_1.

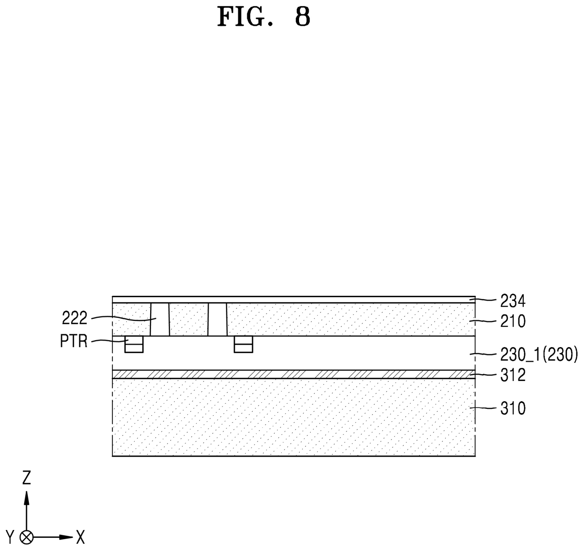

Referring to FIG. 8, a structure where the second substrate 210 is bonded to the first carrier substrate 310 may be reversed.

Subsequently, a grinding process for removing a thickness of a portion of a surface of the second substrate 210 may be performed. The grinding process may be performed so that an upper surface (in the orientation shown in FIG. 8) of the via insulation layer 222 is exposed. A thickness of the second substrate 210 may be reduced by the grinding process.

Subsequently, a second interlayer insulation layer 234 may be formed on an upper surface of the second substrate 210. The second interlayer insulation layer 234 may be formed to cover the upper surface of the second substrate 210 and an entire upper surface of the via insulation layer 222.

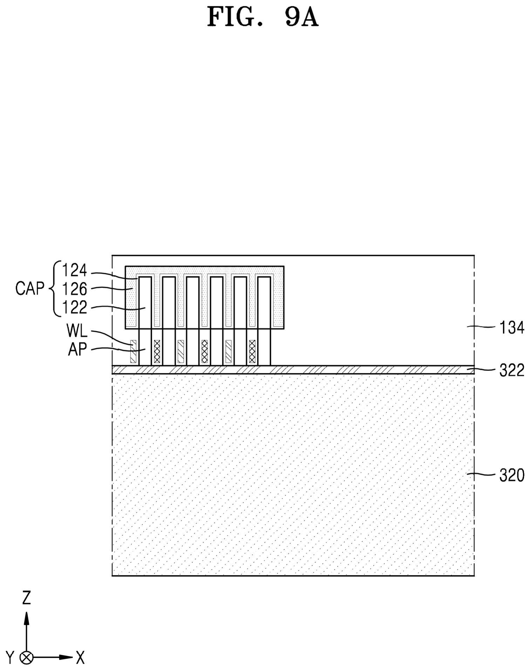

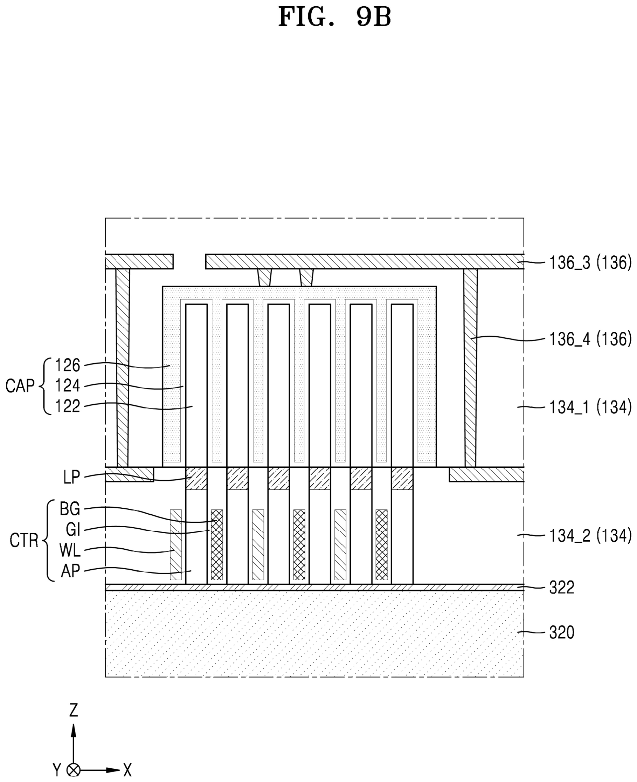

Referring to FIGS. 9A and 9B, a cell transistor CTR may be formed on the second carrier substrate 320. For example, a channel layer AP, a word line WL, a back gate line BG, and a gate insulation layer GI, which are elements of the cell transistor CTR, may be first formed.

In embodiments, the channel layer AP may extend in a vertical direction Z, and the gate insulation layer GI may be formed at each of both sides of the channel layer AP. Subsequently, the word line WL may be formed on one sidewall of the channel layer AP with the gate insulation layer GI therebetween, and the back gate line BG may be formed on the other sidewall of the channel layer AP with the gate insulation layer GI therebetween.

In some embodiments, an interface insulation layer 322 may be disposed between the second carrier substrate 320 and the channel layer AP. In embodiments, the second carrier substrate 320, the interface insulation layer 322, and the channel layer AP may be a portion of a wafer of a silicon-on-insulator (SOI) type. For example, the wafer of the SOI type where the interface insulation layer 322 and a silicon layer are disposed on the second carrier substrate 320 may be provided, and the channel layer AP may be formed by patterning the silicon layer.

In other embodiments, the second carrier substrate 320 may be provided as a wafer of a bulk silicon type. The interface insulation layer 322 may be formed on the second carrier substrate 320, and the channel layer AP may be formed on the interface insulation layer 322 by an epitaxial process, a chemical vapor deposition (CVD) process, and an atomic layer deposition (ALD) process.

In embodiments, the cell transistor CTR may be formed on the second carrier substrate 320, and a second buried insulation layer 134_2 covering the cell transistor CTR may be formed.

Subsequently, a cell capacitor CAP may be formed on the cell transistor CTR and the second buried insulation layer 134_2. In embodiments, a first electrode 122 extending in a vertical direction Z may be formed on each channel layer AP (or on a landing pad LP connected to the channel layer AP), and a capacitor dielectric layer 124 and a second electrode 126 may be sequentially formed on the first electrode 122.

Subsequently, a first buried insulation layer 134_1 covering the cell capacitor CAP may be formed. In embodiments, the first buried insulation layer 134_1 may include a plurality of insulation layers. For example, a second wiring 136_3 may be formed on each of a plurality of insulation layers configuring the first buried insulation layer 134_1, and a second contact 136_4 passing through at least one of the plurality of insulation layers configuring the first buried insulation layer 134_1 may be formed.

Here, the first buried insulation layer 134_1 and the second buried insulation layer 134_2 may be referred to as a buried insulation layer 134.

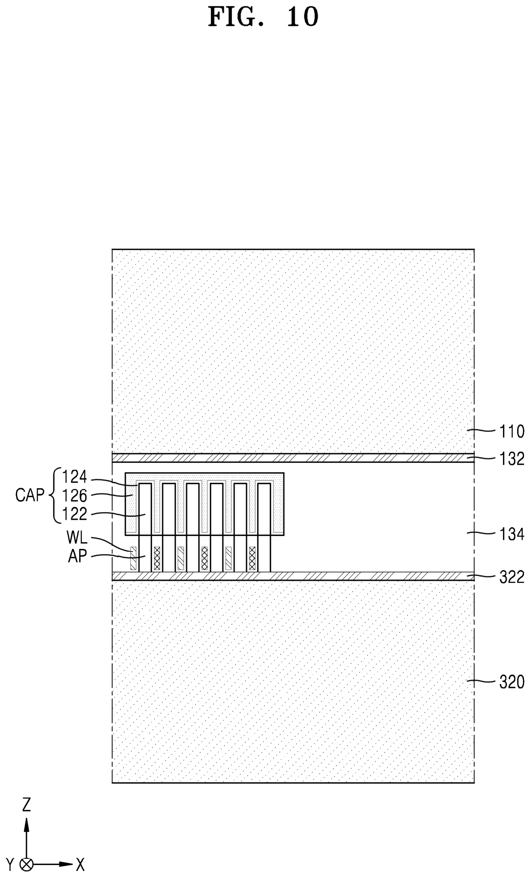

Referring to FIG. 10, a first substrate 110 may be attached to the buried insulation layer 134. For example, the first substrate 110 may be attached to the buried insulation layer 134 with the interface insulation layer 132 therebetween.

In embodiments, the interface insulation layer 132 may be formed on the first substrate 110, and the interface insulation layer 132 may bond the second carrier substrate 320 to the first substrate 110 to contact an upper surface of the buried insulation layer 134 (e.g., the first buried insulation layer 134_1 (see FIG. 9B)).

In embodiments, the interface insulation layer 132 may include at least one from among silicon oxide, silicon nitride, silicon oxynitride, and silicon carbon nitride.

In some embodiments, the interface insulation layer 132 may be bonded to the buried insulation layer 134 by an oxide bonding process. In some embodiments, plasma treatment may be performed on a surface of each of the interface insulation layer 132 and the buried insulation layer 134. In some embodiments, surface treatment using a chemical material may be performed on the surface of each of the interface insulation layer 132 and the buried insulation layer 134. In some embodiments, high temperature annealing may be performed on the surface of each of the interface insulation layer 132 and the buried insulation layer 134.

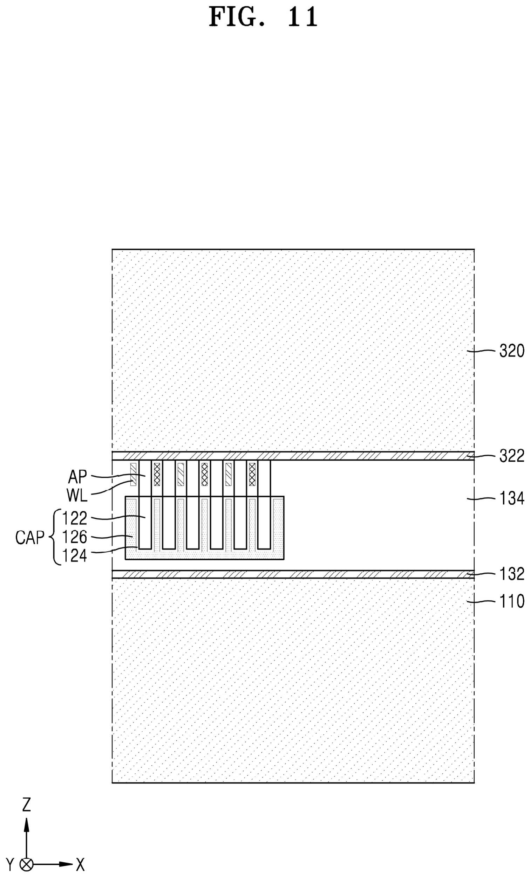

Referring to FIG. 11, a structure where the first substrate 110 is bonded to the second carrier substrate 320 may be reversed.

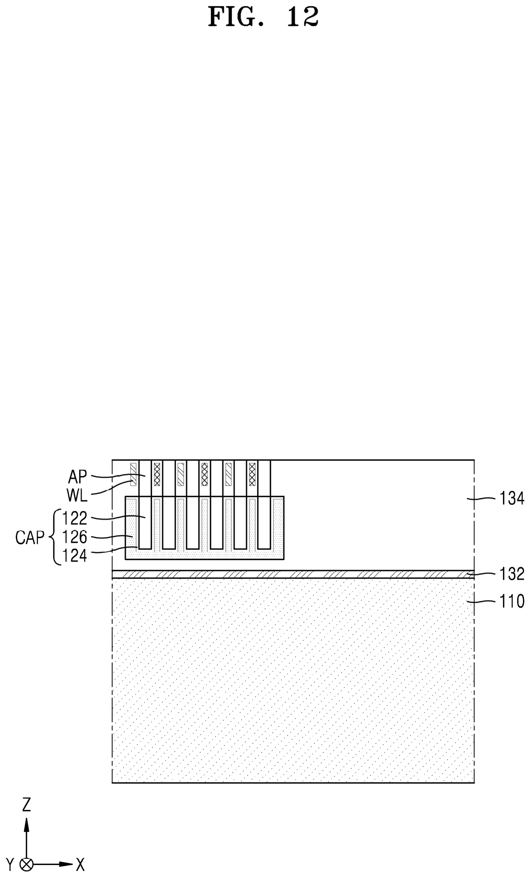

Referring to FIG. 12, the second carrier substrate 320 (see FIG. 11) may be removed. In embodiments, the second carrier substrate 320 may be removed by performing a grinding process and/or an etching process so that an upper surface of the interface insulation layer 322 is exposed.

Subsequently, an upper surface of each of the buried insulation layer 134 and a plurality of channel layers AP may be exposed by removing the interface insulation layer 322.

In some embodiments, a source/drain region may be formed in an upper side of each of the plurality of channel layers AP by implanting an impurity ion into a portion of the upper surface of each of the plurality of channel layers AP.

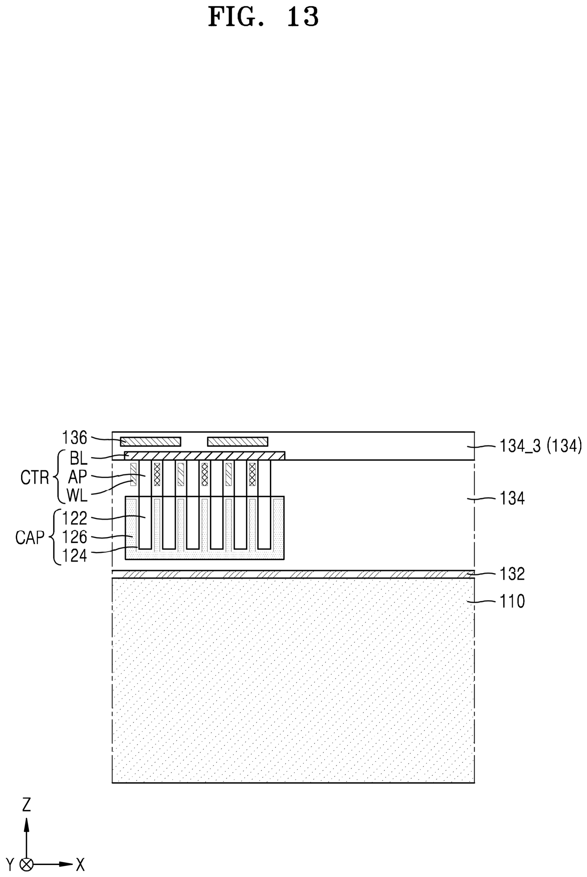

Referring to FIG. 13, a bit line BL extending in a first horizontal direction X may be formed on the upper surface of each of the plurality of channel layers AP. The bit line BL may be electrically connected to a set of channel layers AP which are disposed apart from one another in the first horizontal direction X.

Subsequently, the first contact 136_2 (see FIG. 4) and a wiring structure 136 (e.g., the first wiring 136_1 electrically connected to the bit line BL, the word line WL, and the back gate line BG) (see FIG. 4) electrically connected to the bit line BL, the word line WL, and the back gate line BG may be formed, and a third buried insulation layer 134_3 covering the bit line BL, the first wiring 136_1, and the first contact 136_2 may be formed.

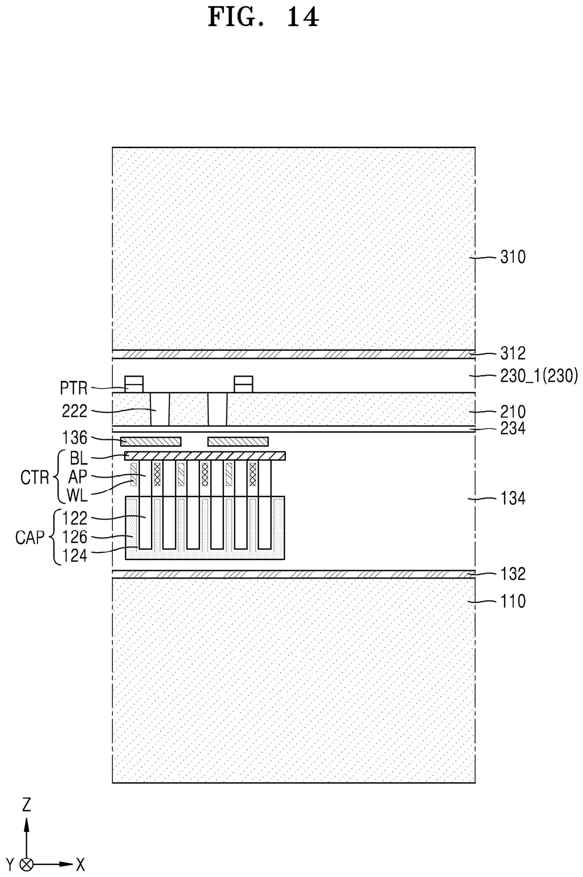

Referring to FIG. 14, the first carrier substrate 310 may be bonded to the first substrate 110.

In embodiments, the first carrier substrate 310 may be bonded to the first substrate 110 so that the second substrate 210 is disposed at a vertical level which is higher than a vertical level of the cell transistor CTR disposed on the first substrate 110.

In embodiments, a peripheral circuit transistor PTR may be disposed on the upper surface of the second substrate 210, and the second interlayer insulation layer 234 may be disposed on a lower surface of the second substrate 210. Here, the second substrate 210 may be disposed at a vertical level which is higher than a vertical level of the first substrate 110 so that the second interlayer insulation layer 234 is disposed on an upper surface of the buried insulation layer 134 (e.g., the third buried insulation layer 134_3). A lower surface of the second interlayer insulation layer 234 may contact the upper surface of the buried insulation layer 134.

In embodiments, the second interlayer insulation layer 234 may be bonded to the buried insulation layer 134 by an oxide bonding process. In some embodiments, plasma treatment may be performed on a surface of each of the second interlayer insulation layer 234 and the buried insulation layer 134. In some embodiments, surface treatment using a chemical material may be performed on the surface of each of the second interlayer insulation layer 234 and the buried insulation layer 134. In some embodiments, high temperature annealing may be performed on the surface of each of the second interlayer insulation layer 234 and the buried insulation layer 134.

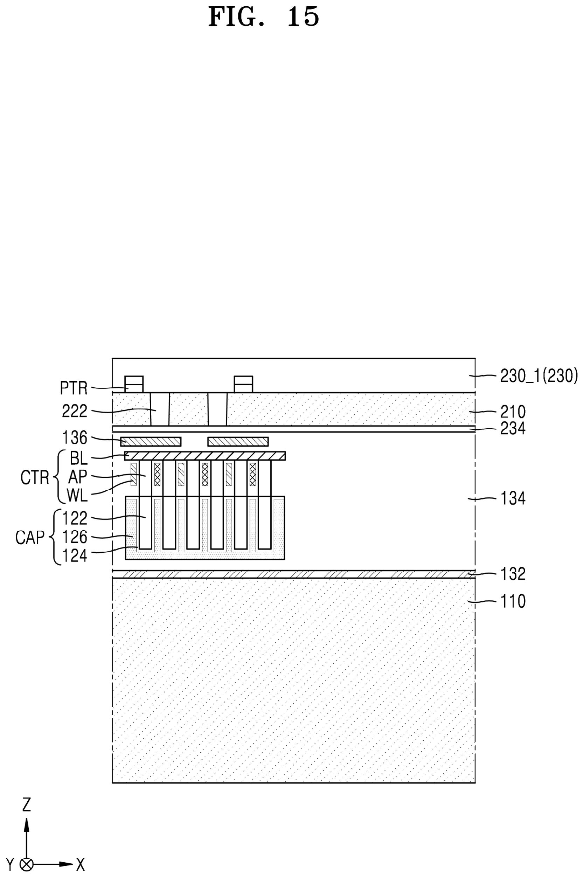

Referring to FIG. 15, the first carrier substrate 310 (see FIG. 14) may be removed. In embodiments, the first carrier substrate 310 may be removed by performing a grinding process and/or an etching process so that the upper surface of the interface insulation layer 312 (see FIG. 14) is exposed.

Subsequently, an upper surface of the first wiring insulation layer 230_1 may be exposed by removing the interface insulation layer 312.

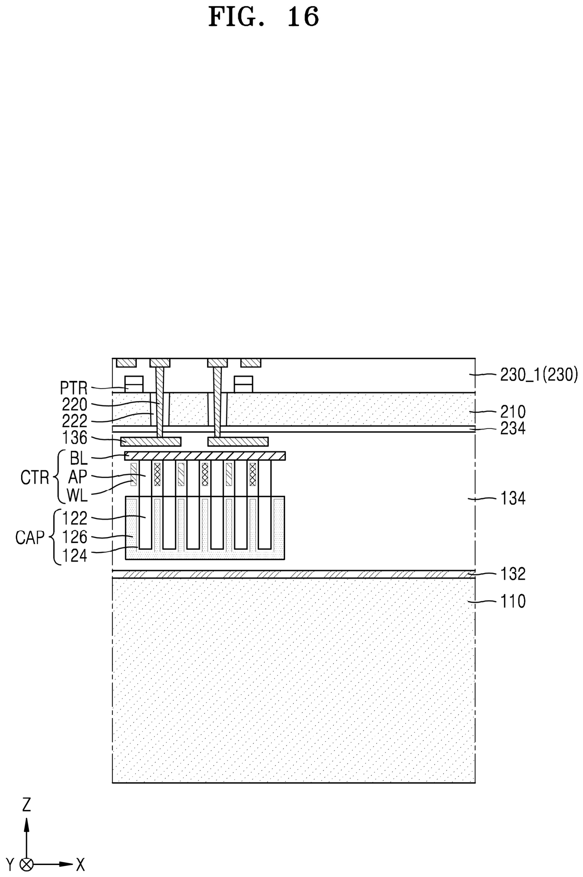

Referring to FIG. 16, a mask pattern may be formed on an upper surface of the first wiring insulation layer 230_1, and a portion of the first wiring insulation layer 230_1 and a portion of the via insulation layer 222 may be removed using the mask pattern as an etch mask, and then, a through via contact 220 may be formed by filling a conductive material in a region from which each of the portion of the first wiring insulation layer 230_1 and the portion of the via insulation layer 222 have been removed. The through via contact 220 may pass through the first wiring insulation layer 230_1 and the via insulation layer 222 and may extend in the vertical direction Z. The through via contact 220 may be disposed on the cell wiring structure 136 and may be electrically connected to the cell wiring structure 136.

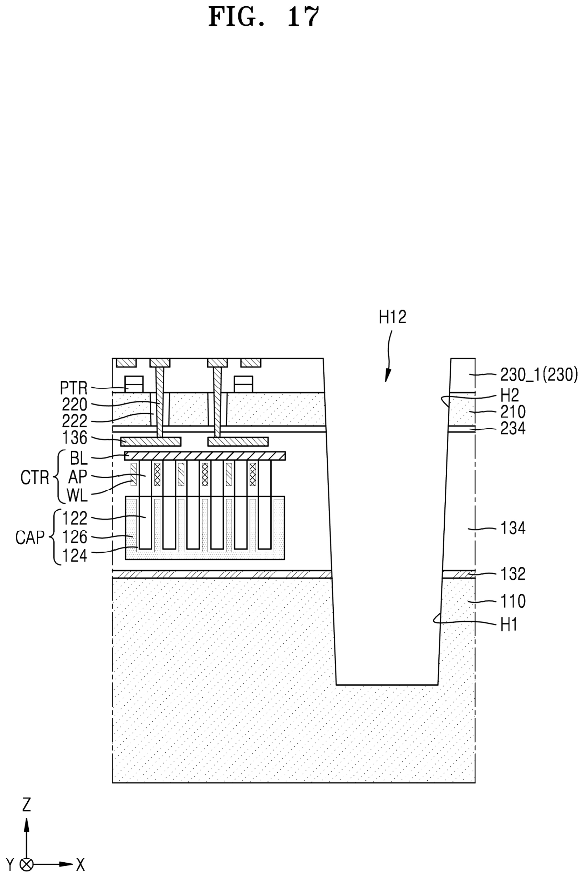

Referring to FIG. 17, a mask pattern may be formed on the upper surface of the first wiring insulation layer 230_1, and a through via hole H12 passing through a portion of the first wiring insulation layer 230_1, a portion of the second substrate 210, a portion of the second interlayer insulation layer 234, a portion of the buried insulation layer 134, and a portion of the first substrate 110 may be formed using the mask pattern as an etch mask. For example, the through via hole H12 may pass through the second substrate 210 and may extend in the vertical direction Z, and the through via hole H12 may not pass all the way through the first substrate 110.

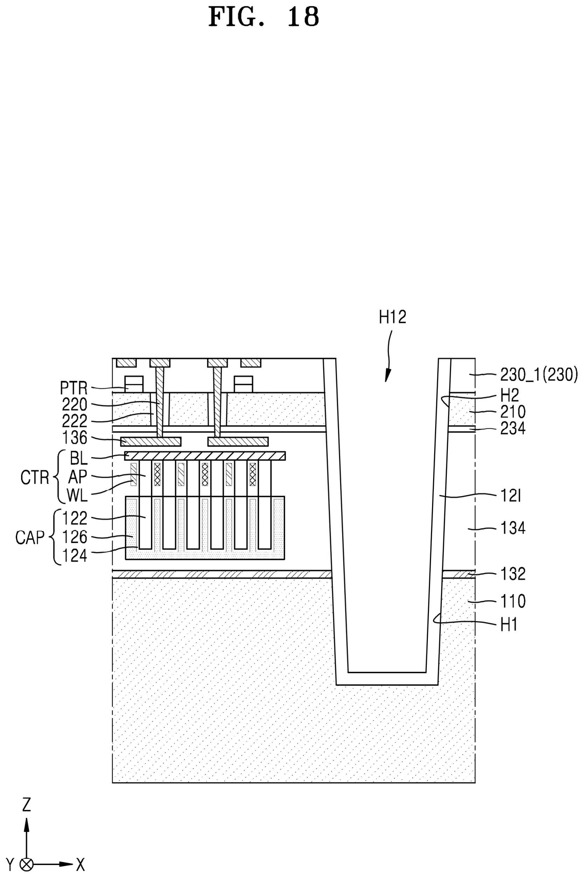

Referring to FIG. 18, a through via insulation layer 12I may be formed on an inner wall of the through via hole H12. The through via insulation layer 12I may include silicon oxide, silicon nitride, or silicon oxynitride.

In embodiments, the through via insulation layer 12I may be formed on the through via hole H12 to have a relatively uniform thickness.

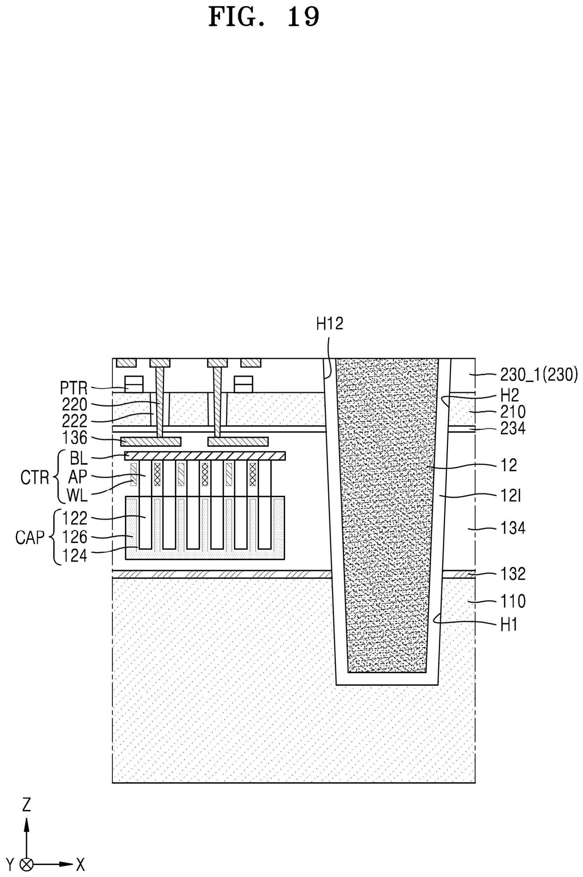

Referring to FIG. 19, a through via 12 may be formed in the through via hole H12.

In embodiments, the through via 12 may be formed by an electroplating process or an electroless plating process using copper or a copper alloy. In embodiments, before the through via 12 is formed, a seed layer may be further formed on an inner wall of the through via hole H12 by a sputtering process using copper, titanium, silver, or platinum.

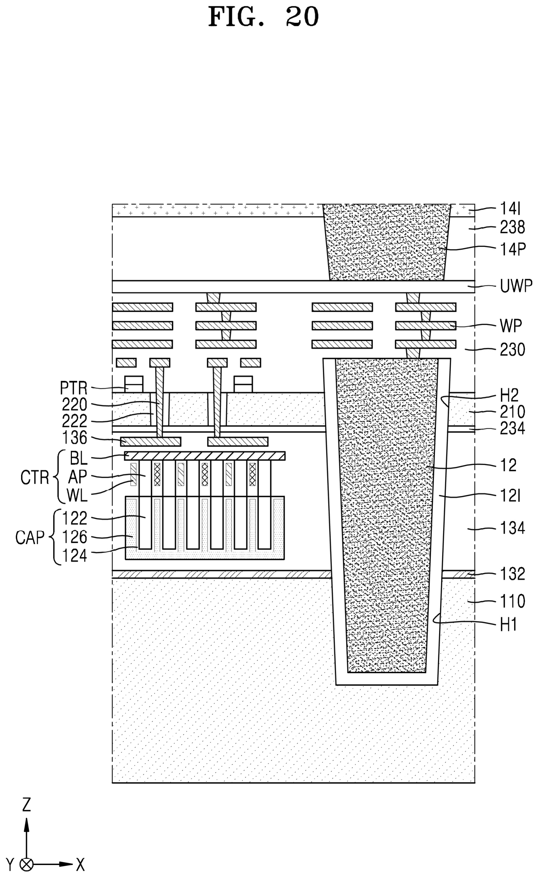

Referring to FIG. 20, a wiring pattern WP and a wiring insulation layer 230 may be formed on an upper surface of the through via 12. A portion of the wiring pattern WP and a portion of the wiring insulation layer 230 may be disposed at positions vertically overlapping with the through via 12, and the wiring pattern WP may be electrically connected to the through via 12.

Subsequently, a lower pad UWP electrically connected to the wiring pattern WP may be formed on the wiring insulation layer 230. A third interlayer insulation layer 238 may be formed on the lower pad UWP, and a front-side insulation layer 14I may be formed on the third interlayer insulation layer 238.

Subsequently, a front-side pad opening portion may be formed by removing a portion of each of the front-side insulation layer 14I and the third interlayer insulation layer 238, and a front-side pad 14P may be formed in the front-side pad opening portion.

In embodiments, the front-side pad 14P may be formed by an electroplating process or an electroless plating process using copper or a copper alloy. In embodiments, before the front-side pad 14P is formed, a seed layer may be further formed on an inner wall of the front-side pad opening portion by a sputtering process using copper, titanium, silver, or platinum.

In embodiments, by performing a planarization process such as a chemical mechanical polishing process on an upper side of the front-side pad 14P, a portion of the upper side of the front-side pad 14P may be removed so that an upper surface of the front-side pad 14P and an upper surface of the front-side insulation layer 14I are disposed coplanar with each other.

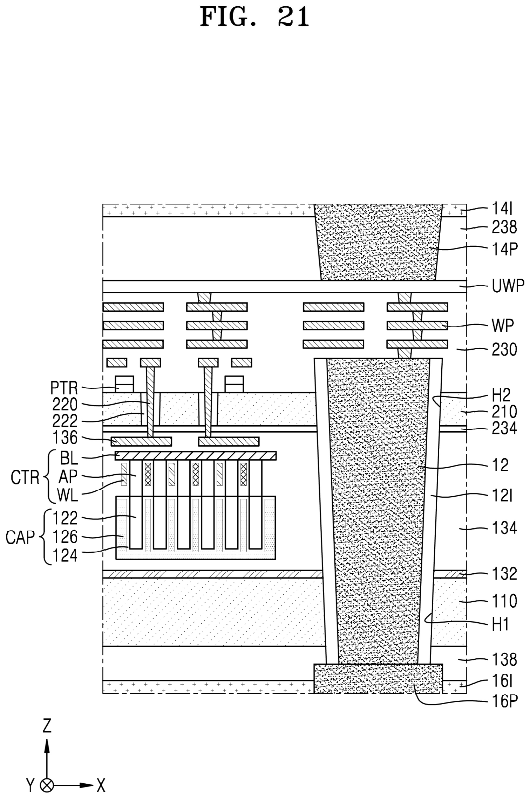

Referring to FIG. 21, a partial thickness of the first substrate 110 may be removed from a lower surface of the first substrate 110. In embodiments, a process for removing a portion of the lower surface of the first substrate 110 may be a grinding process. In embodiments, the grinding process may be performed so that a lower surface of the through via insulation layer 12I disposed on a lower surface of the through via 12 is exposed. In other embodiments, in a state where the lower surface of the through via insulation layer 12I is exposed after the grinding process, an etching process for further removing a partial thickness of the first substrate 110 from the lower surface of the first substrate 110 may be further performed.

In embodiments, a portion of the through via insulation layer 12I disposed at the lower surface of the through via 12 may be removed, and the lower surface of the through via 12 may be exposed. In embodiments, the lower surface of the through via 12 may be disposed at a level which is lower than a level of the lower surface of the first substrate 110, and the lower surface of the through via 12 may protrude downward with respect to the lower surface of the first substrate 110.

Subsequently, a first interlayer insulation layer 138 may be formed to have a sufficient thickness for covering a bottom portion of the through via 12 on the lower surface of the first substrate 110. Subsequently, a backside insulation layer 16I may be formed on a lower surface of the first interlayer insulation layer 138.

A backside pad opening portion again exposing the lower surface of the through via 12 may be formed by removing a portion of the backside insulation layer 16I and a portion of the first interlayer insulation layer 138, and a backside pad 16P may be formed in the backside pad opening portion.

In embodiments, the backside pad 16P may be formed by an electroplating process or an electroless plating process using copper or a copper alloy. In embodiments, before the backside pad 16P is formed, a seed layer may be further formed on an inner wall of the backside pad opening portion by a sputtering process using copper, titanium, silver, or platinum.

In embodiments, by performing a planarization process such as a chemical mechanical polishing process on a bottom portion of the backside pad 16P, a portion of a lower side of the backside pad 16P may be removed so that a lower surface of the backside pad 16P and a lower surface of the backside insulation layer 16I are disposed coplanar with each other.

By performing the process described above, one semiconductor die 10 may be formed. According to embodiments, the process may be performed multiple times to form a plurality of the semiconductor dies 10.

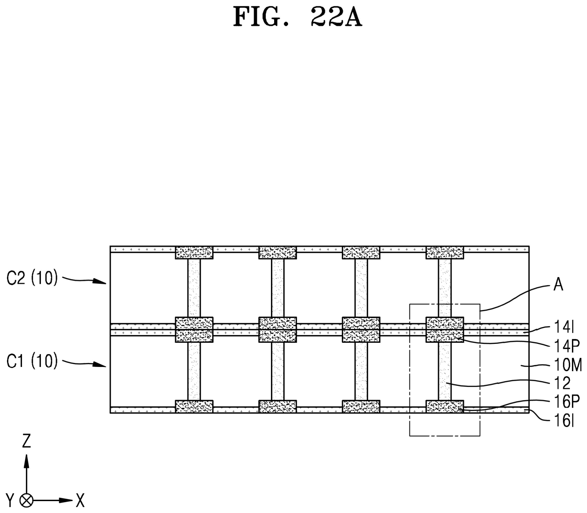

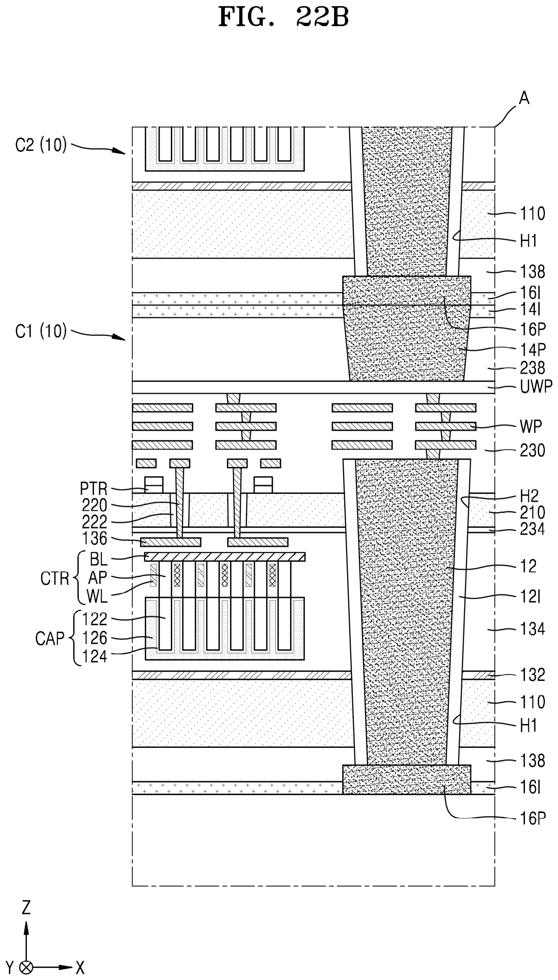

Referring to FIGS. 22A and 22B, one semiconductor die 10 (e.g., a first die C1) may be bonded to another semiconductor die 10 (e.g., a second die C2).

A process of bonding the first die C1 to the second die C2 may include a metal-oxide hybrid bonding process. In embodiments, a front-side pad 14P included in the first die C1 may contact a backside pad 16P included in the second die C2, and a front-side insulation layer 14I included in the first die C1 may contact a backside insulation layer 16I included in the second die C2.

In this manner, a plurality of semiconductor dies 10 may be stacked in the vertical direction Z by a metal-oxide hybrid bonding process, and thus, the semiconductor device 1 described above with reference to FIGS. 1 to 4 may be manufactured.

According to embodiments, each of the semiconductor dies 10 may include the cell transistor CTR of the vertical channel transistor type disposed on the first substrate 110, the peripheral circuit transistor PTR disposed on the second substrate 210, and the through via 12 passing through the first substrate 110, the buried insulation layer 134, and the second substrate 210, and the plurality of semiconductor dies 10 may be stacked in the vertical direction Z through the front-side pad 14P and the backside pad 16P. The semiconductor device 1 may be high in degree of integration, and moreover, may have good electrical performance.

According to an embodiment, each semiconductor die may include a vertical channel transistor disposed on a first substrate and a peripheral circuit transistor disposed on a second substrate and may also include a through via passing through the first substrate and the second substrate, and a plurality of dies may be stacked in a vertical direction and connected by a front-side pad and a backside pad. The semiconductor device may be high in degree of integration, and moreover, may have good electrical performance.

Hereinabove, non-limiting example embodiments have been described with reference to the accompanying drawings. Embodiments have been described by using the terms described herein, but these terms have been merely used for describing example embodiments and have not been used for limiting a meaning or limiting the scope of the disclosure. Therefore, it may be understood by those of ordinary skill in the art that various modifications and other equivalent embodiments may be included in the scope of the disclosure.

While non-limiting example embodiments have been described with reference to the accompanying drawings, it will be understood that various changes in form and details may be made therein without departing from the scope of disclosure.

## Claims

1. A semiconductor device comprising:
a plurality of dies (10) stacked in a vertical direction (Z),
wherein each of the plurality of dies (10) comprises:
a first substrate (110);
a cell capacitor (CAP) on the first substrate (110);
a cell transistor (CTR) on the cell capacitor (CAP);
a second substrate (210), wherein a vertical level of the second substrate (210) is higher than a vertical level of the cell transistor (CTR);
a peripheral circuit transistor (PTR) on the second substrate (210); and
a through via (12) passing through the first substrate (110) and the second substrate (210) in the vertical direction (Z).

2. The semiconductor device of claim 1, wherein each of the plurality of dies (10) further comprises:
a wiring pattern (WP) that at least partially vertically overlaps with the through via (12), wherein a vertical level of the wiring pattern (WP) is higher than a vertical level of the peripheral circuit transistor (PTR);
a front-side pad (14P) on an upper surface of the wiring pattern (WP) ; and
a backside pad (16P) on a lower surface of the through via (12).

3. The semiconductor device of claim 2, wherein the plurality of dies (10) comprise a first die (C1) and a second die (C2) on the first die (C3), and
the through via (12) of the first die (C1) and the through via (12) of the second die (C2) are electrically connected to each other, and the second die (C2) is on an upper surface of the first die (C1) such that the backside pad of the second die (C2) is attached to the front-side pad (14P) of the first die (C1).

4. The semiconductor device of claim 2 or 3, wherein each of the plurality of dies (10) further comprises:
a front-side insulation layer (14I) on the upper surface of the wiring pattern (WP), and an upper surface of the front-side insulation layer (14I) is coplanar with an upper surface of the front-side pad (14P); and
a backside insulation layer (16I) on a lower surface of the first substrate (110), and a lower surface of the backside insulation layer (16I) is coplanar with a lower surface of the backside pad (16P),
the plurality of dies (10) comprise a first die (C1) and a second die (C2) on the first die (C1), and
the upper surface of the front-side insulation layer (14I) of the first die (C1) contacts a lower surface of the backside insulation layer (16I) of the second die (C2).

5. The semiconductor device of any one of claims 2 to 4, wherein each of the plurality of dies (10) further comprises a through via contact (220) extending in the vertical direction (Z) in a via hole (210H) passing through the second substrate (210) and electrically connecting the peripheral circuit transistor (PTR) to the cell transistor (CTR).

6. The semiconductor device of any one of claims 1 to 5, wherein the cell transistor (CTR) comprises:
a channel layer (AP) extending in the vertical direction (Z);
a word line (WL) on one sidewall of the channel layer (AP) and extending in a first horizontal direction; and
a bit line (BL) on an upper surface of the channel layer (AP) and extending in a second horizontal direction intersecting with the first horizontal direction.

7. The semiconductor device of claim 6, wherein the channel layer (AP) comprises silicon, germanium, silicon germanium, or an oxide semiconductor.

8. The semiconductor device of any one of claims 1 to 7, wherein each of the plurality of dies (10) further comprises a through via insulation layer (12I) surrounding a sidewall of the through via (12),
the first substrate (110) comprises a first through via hole (H1) passing through the first substrate (110),
the second substrate (210) comprises a second through via hole (H2) passing through the second substrate (210), the second through via hole (H2) vertically overlapping with the first through via hole (H1).

9. The semiconductor device of claim 8, wherein the through via (12) is vertically overlapping with the first through via hole (H1) and the second through via hole (H2).

10. The semiconductor device of claim 8 or 9, wherein the through via (12) comprises an upper surface, wherein a vertical level of the upper surface of the through via (12) is higher than a vertical level of an upper surface of the second substrate (210), and
the through via (12) comprises a lower surface, wherein a vertical level of the lower surface of the through via (12) is lower than a vertical level of a lower surface of the first substrate (110).

11. The semiconductor device of any one of claims 8 to 10, wherein the through via insulation layer (12I) comprises an upper surface, wherein a vertical level of the upper surface of the through via insulation layer (12I) is higher than a vertical level of an upper surface of the second substrate (210), and
the through via insulation layer (12I) comprises a lower surface, wherein a vertical level of the lower surface of the through via insulation layer (12I) is lower than a vertical level of a lower surface of the first substrate (110).

12. The semiconductor device of any one of claims 8 to 11, wherein a first portion of the through via insulation layer (12I) is between the sidewall of the through via (12) and an inner wall of the first through via hole (H1),
a second portion of the through via insulation layer (12I) is between the sidewall of the through via (12) and an inner wall of the second through via hole (H2).

13. The semiconductor device of claim 12, wherein the through via (12) is electrically insulated from the first substrate (110) or the second substrate (210).

14. The semiconductor device of any one of claims 8 to 13, wherein each of the plurality of dies (10) further comprises:
a buried insulation layer (134) between the first substrate (110) and the second substrate (210) and on the cell transistor (CTR).

15. The semiconductor device of claim 14, wherein the through via insulation layer (12I) is on an entire sidewall of the through via (12), and
at least a portion of a sidewall of the through via insulation layer (12I) contacts the buried insulation layer (134).
